# EUROPEAN PATENT APPLICATION

(11) **EP 4 683 489 A1**
(43) Date of publication of application: **21.01.2026**
(21) Application number: 25182930.5
(22) Date of filing: 16.06.2025
(51) Int. Cl.: H10W 20/43, H10W 20/44, H10W 20/40

(54) **CONDUCTIVE WIRES AND INTERCONNECT STRUCTURE AND SEMICONDUCTOR DEVICE**

(30) Priority: 11.07.2024 KR 20240091578
(71) Applicant: Samsung Electronics Co., Ltd., Suwon-si, Gyeonggi-do 16677 (KR)
(72) Inventor: SHIN, Keun Wook, 16678 Suwon-si (KR); KIM, Joonseok, 16678 Suwon-si (KR); KIM, Sangwon, 16678 Suwon-si (KR); KIM, Changhyun, 16678 Suwon-si (KR); YANG, Daejin, 16678 Suwon-si (KR); LEE, Jeongyub, 16678 Suwon-si (KR); JO, Giyoung, 16678 Suwon-si (KR)
(74) Representative: Elkington and Fife LLP

(57) **Abstract**

A conductive wire including a topological semimetal and a two-dimensional material, an interconnect structure including one or more dielectric layers and a first conductive wire, including the topological semimetal and the two-dimensional material, and a semiconductor device including the conductive wire or the interconnect structure.

## Description

### FIELD OF THE INVENTION

Conductive wires, interconnect structures, and semiconductor devices are described.

### BACKGROUND OF THE INVENTION

In order to provide highly integrated, high-performance integrated circuit devices, technologies for reducing the size of unit devices that constitute integrated circuit devices are being studied, and accordingly, there is a demand to also reduce a line width of the wire that electrically connects the unit devices.

### SUMMARY OF THE INVENTION

However, if the wire width is reduced below a certain range, the resistance may increase rapidly due to material limitations, which may deteriorate the electrical characteristics.

An embodiment provides a conductive wire that may reduce or prevent degradation of electrical characteristics even at reduced line widths.

Another embodiment provides an interconnect structure including the conductive wire.

Another embodiment provides a semiconductor device including the conductive wire or the interconnect structure.

According to an embodiment, a conductive wire including a topological semimetal and a two-dimensional material is provided.

The conductive wire may include a first layer including the topological semimetal, and a second layer at least partially in contact with the first layer and including the two-dimensional material.

A line width of the first layer may be less than about 10 nanometers (nm), and a line width of the second layer may be narrower than a line width of the first layer.

A line width of the first layer may be about 2 to about 30 times wider than a line width of the second layer.

The first layer may have a first surface and a second surface facing each other, the second layer may be in contact with the first surface of the first layer, and the conductive wire may further include a third layer in contact with the second surface of the first layer and the third layer includes the two-dimensional material.

The first layer and the second layer may be included as a plurality, and the first layer and the second layer may be alternately stacked.

The two-dimensional material may include a two-dimensional metal dichalcogenide, a two-dimensional metal oxide, a two-dimensional metal halide, graphene, phosphorene, silicene, germanene, stanene, borophene, hexagonal boron nitride, or a combination thereof.

The topological semimetal may be represented by Chemical Formula 1.

Chemical Formula 1 M¹Xₐ

In Chemical Formula 1,
M¹ is Zr, Nb, Ru, Al, Co, W, Mo, Ti, Ta, Ni, Pt, Cr, Rh, Ir, Pd, Os, Hf, Re, Sn, Mn, Ga, or a combination thereof,
X is C, N, P, As, Sb, S, Se, Te, or a combination thereof, and
a is a number determined by the stoichiometry of M¹ and X.

The two-dimensional material may be different from the topological semimetal and may be represented by Chemical Formula 2.

Chemical Formula 2 M²Y₂

In Chemical Formula 2,
M² is Mo, W, Nb, Ti, Ta, Pt, Pd, Co, Cr, Ni, Hf, Re, Sn, Zr, Mn, Ga, or a combination thereof, and
Y is S, Se, Te, or a combination thereof.
M¹ of Chemical Formula 1 and M² of Chemical Formula 2 may include at least one metal in common.

According to another embodiment, an interconnect structure includes one or more dielectric layers; and a first conductive wire positioned on at least one of an upper portion, a lower portion, a side portion, or an inner portion of the one or more dielectric layers and the first conductive wire may include a topological semimetal and a two-dimensional material.

The dielectric layer may have a trench having a width of less than or equal to about 10 nm, and the first conductive wire may include a first layer including the topological semimetal positioned within the trench, and a second layer including the two-dimensional material contacting at least one of a lower portion, an upper portion, or a side portion of the first layer.

The second layer may be positioned between the dielectric layer and the first layer.

A line width of the first layer may be less than about 10 nm, and a line width of the first layer may be about 2 to about 30 times a line width of the second layer.

The dielectric layer may be an airgap or may include an airgap.

The interconnect structure may further include a second conductive wire positioned at a different height from the first conductive wire, and a via that electrically connects the first conductive wire and the second conductive wire respectively, wherein the via may include the topological semimetal, the two-dimensional material, or a combination thereof.

The two-dimensional material may include a two-dimensional metal dichalcogenide, a two-dimensional metal oxide, a two-dimensional metal halide, graphene, phosphorene, silicene, germanene, stanene, borophene, hexagonal boron nitride, or a combination thereof.

The topological semimetal may be represented by Chemical Formula 1 described above, the two-dimensional material may be different from the topological semimetal and may be represented by Chemical Formula 2 described above, and M¹ of Chemical Formula 1 and M² of Chemical Formula 2 may include at least one metal in common.

According to another embodiment, a semiconductor device including the conductive wire or the interconnect structure is provided.

Deterioration of electrical characteristics in wire with a fine line width of less than about 10 nm may be reduced or prevented.

### BRIEF DESCRIPTION OF THE DRAWINGS

FIG. 1 is a schematic view showing an example of a conductive wire according to an embodiment,
FIG. 2 is a schematic view showing another example of a conductive wire according to an embodiment,
FIG. 3 is a schematic view showing another example of a conductive wire according to an embodiment,
FIG. 4 is a schematic diagram showing another example of a conductive wire according to an embodiment,
FIG. 5, FIG, 6, and FIG. 7 are schematic views showing further examples of conductive wires according to embodiments, respectively,
FIG. 8 and FIG. 9 are schematic views showing further examples of conductive wires according to embodiments, respectively,
FIG. 10, FIG. 11, FIG. 12, FIG. 13, and FIG. 14 are cross-sectional views showing examples of interconnect structures according to embodiments,
FIG. 15 is a cross-sectional view showing another example of an interconnect structure according to an embodiment,
FIGS. 16 and 17 are cross-sectional views showing other examples of interconnect structures according to embodiments,
FIG. 18 is a conceptual view showing an example of an electronic device according to an embodiment, and
FIG. 19 is a graph showing the resistivity characteristics (R/Rₘₐₓ) versus thickness (nm) of wire according to an Example and a Reference Example.

### DETAILED DESCRIPTION

Hereinafter, the embodiments will be described in detail so that those of ordinary skill in the art may easily implement them. However, the actually applied structure may be implemented in several different forms and is not limited to the embodiments described herein.

The terminology used herein is used to describe embodiments only, and is not intended to limit the present disclosure. The singular expression, e.g., "a," includes the plural expression unless the context clearly dictates otherwise.

Herein, it should be understood that terms such as "comprises," "includes," or "have" are intended to designate the presence of an embodied feature, number, step, element, or a combination thereof, but it does not preclude the possibility of the presence or addition of one or more other features, number, step, element, or a combination thereof.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it may be directly on the other element or intervening elements may also be present. In contrast, when an element is referred to as being "directly on" another element, there are no intervening elements present.

The drawings and description are to be regarded as illustrative in nature and not restrictive. Like reference numerals designate like elements throughout the specification.

It will be understood that when a component is referred to as being "on" or "above" another component, the component may be directly on, under, on the left of, or on the right of the other component, or may be on, under, on the left of, or on the right of the other component in a non-contact manner. In addition, unless explicitly described to the contrary, the word "comprise," and variations such as "comprises" or "comprising," will be understood to imply the inclusion of stated elements.

The term "layer" includes a construction having a shape formed on a part of a region, in addition to a construction having a shape formed on an entire region.

As used herein, the term "the" or similar indicative terms correspond to both the singular form and the plural form. The steps of all methods described herein may be performed in any suitable order unless otherwise indicated herein or otherwise clearly contradicted by context.

Here, "combination thereof" refers to a mixture, a stacked structure, a composite, an alloy, a blend of constituents, or the like, or a combination thereof.

Hereinafter, unless otherwise defined, "substantially" or "approximately" or "about" includes not only the stated value, but also the average within an allowable range of deviation, considering the error associated with the measurement and amount of the measurement. For example, "substantially" or "approximately" may mean within ±10%, ±5%, ±3%, or ±1 % of the indicated value or within a standard deviation.

Hereinafter, "metal" is interpreted as a concept including metals and metalloids (semimetals).

The conductive wire according to an embodiment is described.

The conductive wire may include any wire that transmits an electrical signal or requires an electrical connection, and for example, in a semiconductor device, may include any wire that electrically connects between active devices, between passive devices, and/or between an active device and a passive device.

The conductive wire may be a three-dimensional structure having a width, a length, and a thickness, wherein the length direction of the conductive wire may be a direction in which charge carriers (e.g., electrons) move and may be a direction perpendicular to the width direction and the thickness direction, respectively.

The conductive wire according to an embodiment includes a topological semimetal and a two-dimensional material. The topological semimetal and two-dimensional material may be different conductive or semiconductor materials and may be included in at least some contacting distinct layers.

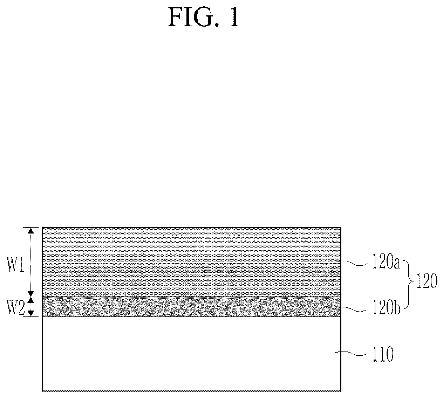

FIG. 1 is a schematic view showing an example of a conductive wire according to an embodiment.

Referring to FIG. 1, a conductive wire 120 according to an embodiment includes a first layer 120a and a second layer 120b. A dielectric layer 110 may be positioned adjacent to the second layer 120b. The first layer 120a and the second layer 120b are at least partially in contact, and the first layer 120a may include a topological semimetal and the second layer 120b may include a two-dimensional material.

The topological semimetal may include at least one metal element and optionally at least one further semimetal elements and/or non-metal elements. The topological semimetal may be a monocrystalline or polycrystalline compound with a predetermined crystal structure, for example a hexagonal close packed lattice (HCP), but is not limited thereto.

Unlike general bulk metals, topological semimetals have less electron scattering at the surface and grain boundaries, which may reduce or prevent a rapid increase in resistivity even when the surface area per volume increases.

For example, a copper electrode including copper (Cu) in the form of a general bulk metal, may be affected by the movement of electrons due to the increase in electron scattering at the metal surface and grain boundaries as the line width decreases, and particularly when the line width narrows to the nanometer level of less than about 10 nm (e.g., less than or equal to about 7 nm), the effect of the line width increases rapidly, causing the resistivity of the copper electrode to increase rapidly and performance degradation due to exothermic effects may also occur.

**In** contrast, topological semimetals, as described above, have little electron scattering at the surface and grain boundaries, so that the change in resistivity with decreasing line width may be very small or nonexistent, and in particular, even when the line width narrows to the nanometer level of less than about 10 nm (e.g., about 9 nm or less or about 7 nm or less), a sharp increase in resistivity may not be observed. For example, the change in resistivity of a topological semimetal due to a decrease in linewidth of about 10% may be less than about 2 times, and within the above range may be about 1.8 times or less, about 1.5 times or less, or about 1.2 times or less. For example, the change in resistivity of a topological semimetal due to a decrease in linewidth may be confirmed by comparing the resistivity of a topological semimetal with a linewidth of about 3 nm with the resistivity of a topological semimetal with a linewidth of about 40 nm. For example, a difference between the resistivity of the topological semimetal with a linewidth of about 3 nm and the resistivity of the topological semimetal with a linewidth of about 40 nm may be less than about 10 times, and within the above range may be about 8 times or less, about 7 times or less, about 5 times or less, about 3 times or less, about 2 times or less, about 1.8 times or less, about 1.5 times or less, or about 1.2 times or less. This may be significantly low, compared that the resistivity of copper with a line width of about 3 nm is about 20 times higher than the resistivity of copper with a line width of about 40 nm.

As an example, a topological semimetal may be represented by Chemical Formula 1.

Chemical Formula 1 M¹Xₐ

In Chemical Formula 1,
M¹ is at least one metal element,
X is at least one semimetal element or non-metal element, and
a is a number determined by the stoichiometry of M¹ and X.

For example, M¹ may be Zr, Nb, Ru, Al, Co, W, Mo, Ti, Ta, Ni, Pt, Cr, Rh, Ir, Pd, Os, Hf, Re, Sn, Mn, Ga, or a combination thereof.

For example, X may be C, N, P, As, Sb, S, Se, Te, or a combination thereof.

For example, the topological semimetal may include MoP, MoTe₂, MoC, MoN, WC, WN, WTe₂, TaN, TaAs, TaP, TaSb₂, NbN, NbS, NbP, ZrTe, Cd₃As₂, or a combination thereof, but is not limited thereto.

The two-dimensional material may be a planar typed inorganic nanomaterial extending along two axes (e.g., X-axis and Y-axis). For example, the length extending along the X-axis and the width extending along the Y-axis may be significantly larger than the thickness extending along the Z-axis, and for example, the length extending along the X-axis and the width extending along the Y-axis may each independently be tens of nanometers to several micrometers, and the thickness extending along the Z-axis may be several nanometers or less.

The two-dimensional material may include one or more monolayers, and Van der Waals gaps with a spacing of several angstroms may be formed between adjacent monolayers, which may control the electrical characteristics of the two-dimensional material.

The two-dimensional material may be a mono-element material or a multi-element material, and the multi-element material may include, for example, at least one metal element, and at least one semimetal element and/or non-metal element. The two-dimensional material may include for example a two-dimensional metal dichalcogenide, a two-dimensional metal oxide, a two-dimensional metal halide, graphene, phosphorene, silicene, germanene, stanene, borophene, hexagonal boron nitride, or a combination thereof. The two-dimensional material may be different from the aforementioned topological semimetal.

For example, the two-dimensional material may be a two-dimensional metal dichalcogenide, and may be represented by, for example, Chemical Formula 2.

Chemical Formula 2 M²Y₂

In Chemical Formula 2,
M² is at least one metal, and
Y is a chalcogen element.
M² may be for example Mo, W, Nb, Ti, Ta, Pt, Pd, Co, Cr, Ni, Hf, Re, Sn, Zr, Mn, Ga, or a combination thereof, and Y may be for example S, Se, Te, or a combination thereof.

For example, the two-dimensional metal dichalcogenide may include MoS₂, MoSe₂, MoSSe, MoSTe, Mo₍₁₋ₓ₎WₓS₂, Mo₍₁₋ₓ₎WₓSe₂, Mo₍₁₋ₓ₎WₓTe₂, Mo₍₁₋ₓ₎NbₓS₂, MO₍₁₋ₓ₎NbₓSe₂, MO₍₁₋ₓ₎TaₓS₂, MO₍₁₋ₓ₎TaₓSe₂, Mo₍₁₋ₓ₎WₓSSe, MoTe₂, WS₂, WSe₂, WSSe, WTe₂, WSTe, W₍₁₋ₓ₎NbₓS₂, W₍₁₋ₓ₎NbₓSe₂, PtS₂, PtSe₂, PtTe₂, PdSe₂, TaS₂, TaSe₂, Ta₍₁₋ₓ₎WₓS₂, Ta₍₁₋ₓ₎WₓSe₂, HfS₂, HfSe₂, HfTe₂, TiS₂, TiSe₂, TiTe₂, NbS₂, NbSe₂, NbTe₂, SnS₂, SnSe₂, SnTe₂, ReS₂, ReSe₂, ReTe₂ (wherein 0≤x≤1), or a combination thereof, but is not limited thereto.

For example, the two-dimensional material other than the two-dimensional metal dichalcogenide may be Ta₂O₅, Ta₃N₅, TaON, Nb₂O₅, TiOₓ, NbOₓ, MnOₓ, VaOₓ (wherein 1≤ x≤ 3), MnO₃, TaO₃, WO₃, MoCl₂, CrCl₃, RuCl₃, Bil₃, PbCl₄, GeS, GeSe, GaSe, In₂Se₃, GaTe, InS, InSe, InTe, h-BN, CoPS₃, CrPS₄, Cu₍₁₋ₓ₎CrₓP₂S₆ (wherein 0≤x≤1), NiPS₃, or a combination thereof, but is not limited thereto.

For example, the topological semimetal and two-dimensional material may include at least one metal element in common. For example, in the topological semimetal represented by Chemical Formula 1 and the two-dimensional material represented by Chemical Formula 2, M¹ of Chemical Formula 1 and M² of Chemical Formula 2 may include at least one metal element in common, for example, molybdenum (Mo), tungsten (W), niobium (Nb), titanium (Ti), tantalum (Ta), platinum (Pt), palladium (Pd), cobalt (Co), chromium (Cr), nickel (Ni), hafnium (Hf), rhenium (Re), tin (Sn), zirconium (Zr), manganese (Mn), gallium (Ga), or a combination thereof, but are not limited thereto.

In this way, since the topological semimetal and the two-dimensional material included in the first layer 120a and the second layer 120b that are in contact with each other include at least one metal element in common, the first layer 120a and the second layer 120b may form a continuous interface and may have a substantially seamless interface, thereby reducing the contact resistance of the conductive wire 120.

For example, the first layer 120a including the topological semimetal may provide a main conductive path of the conductive wire 120, and the topological semimetal may be a main conductor of the conductive wire 120.

The line width W1 of the first layer 120a may be less than about 10 nm as described above, and within the above range may be less than or equal to about 9 nm, less than or equal to about 8 nm, less than or equal to about 7 nm, less than or equal to about 5 nm, greater than or equal to about 1 nm and less than 10 nm, about 1 nm to about 9 nm, about 1 nm to about 8 nm, about 1 nm to about 7 nm, or about 1 nm to about 5 nm. Here, the line width W1 may be a direction (e.g., Y direction) perpendicular to the longitudinal direction (e.g., X direction) in the in-plane along which the conductive wire 120 extends.

For example, a second layer 120b including a two-dimensional material may be in contact with the first layer 120a to improve the interface characteristics between the first layer 120a and the second layer 120b due to the van der Waals gaps between the two-dimensional material and the topological semimetal. Accordingly, a conductive wire 120 with a fine line width of less than about 10 nm (e.g., less than about 7 nm) may exhibit further improved resistivity characteristics. For example, the second layer 120b including the two-dimensional material may function as a passivation layer or barrier layer between the first layer 120a and an adjacent layer (e.g., a dielectric layer).

The line width W2 of the second layer 120b may be narrower than the line width W1 of the first layer 120a, for example, the line width W1 of the first layer 120a may be at least about twice as wide as the line width W2 of the second layer 120b, and may be at least about three times, at least about five times, or at least about ten times as wide within the above range, and may be at least about two to thirty times, at least about three to thirty times, at least about five to thirty times, or at least about ten to thirty times as wide within the above range. For example, the line width W2 of the second layer 120b may be less than about 5 nm, and within the range may be greater than or equal to about 0.5 nm to less than about 5 nm, about 0.5 nm to about 4 nm, about 0.5 nm to about 3 nm, or about 0.5 nm to about 2 nm.

An aspect ratio of the conductive wire 120 may be about 1:3 (line width:thickness) or greater, for example, about 1:3 to about 1:20, about 1:3 to about 1:15, or about 1:3 to about 1:10. Here, the aspect ratio of the conductive wire 120 may be the ratio of the width (e.g., in the Y direction) to the thickness (e.g., in the Z direction) of the conductive wire 120.

In this way, the conductive wire 120 may prevent a rapid increase in resistivity even at a fine line width of less than about 10 nm by including a first layer 120a including the topological semimetal, and reduce or prevent performance degradation due to heat generation. In addition, by further including the second layer 120b including the two-dimensional material in contact with the first layer 120a, the interface characteristics between the first layer 120a and the second layer 120b may be improved by controlling the van der Waals gap between multiple monolayers of the two-dimensional material and/or between the two-dimensional material and the topological semimetal, thereby exhibiting further improved resistivity characteristics at a fine line width of less than about 10 nm (e.g., less than about 7 nm).

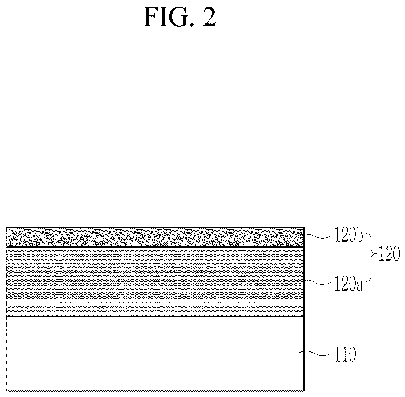

FIG. 2 is a schematic view showing another example of a conductive wire according to an embodiment.

Referring to FIG. 2, a conductive wire 120 according to an embodiment includes a first layer 120a and a second layer 120b formed adjacent to a dielectric layer 110, similar to the above-described example, and the first layer 120a includes a topological semimetal and the second layer 120b includes a two-dimensional material.

However, unlike the above-described embodiment, the conductive wire 120 according to the present embodiment has one side of the first layer 120a including the topological semimetal in contact with the dielectric layer 110 and the other side of the first layer 120a in contact with the second layer 120b including the two-dimensional material. That is, the first layer 120a including the topological semimetal is interposed between the dielectric layer 110 and the second layer 120b. The description of the topological semimetal and the two-dimensional material is as described above.

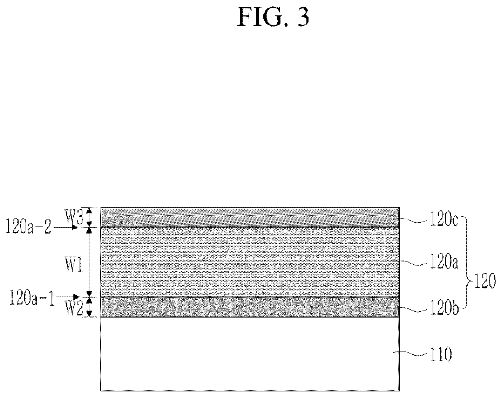

FIG. 3 is a schematic view showing another example of a conductive wire according to an embodiment.

Referring to FIG. 3, a conductive wire 120 according to an embodiment includes a first layer 120a and a second layer 120b formed adjacent to a dielectric layer 110, similar to the above-described example, and the first layer 120a includes a topological semimetal and the second layer 120b includes a two-dimensional material.

However, the conductive wire 120 according to the present embodiment, unlike the above-described embodiment, further includes a third layer 120c containing a two-dimensional material. That is, the first layer 120a of the conductive wire 120 has a first surface 120a-1 and a second surface 120a-2 facing each other, the second layer 120b may contact the first surface 120a-1 of the first layer 120a, and the third layer 120c may contact the second surface 120a-2 of the first layer 120a.

The second layer 120b and the third layer 120c may include the same or different two-dimensional materials. The two-dimensional materials included in the second layer 120b and the third layer 120c may each independently include, for example, a two-dimensional metal dichalcogenide, a two-dimensional metal oxide, a two-dimensional metal halide, graphene, phosphorene, silicene, germanene, stanene, borophene, hexagonal boron nitride, or a combination thereof.

The two-dimensional materials included in the second layer 120b and the third layer 120c may each independently include a two-dimensional metal dichalcogenide represented by Chemical Formula 2 described above, for example, MoS₂, MoSe₂, MoSSe, MoSTe, Mo₍₁₋ₓ₎WₓS₂, Mo₍₁₋ₓ₎WₓSe₂, Mo₍₁₋ₓ₎WₓTe₂, MO₍₁₋ₓ₎NbₓS₂, MO₍₁₋ₓ₎NbₓSe₂, MO₍₁₋ₓ₎TaₓS₂, MO₍₁₋ₓ₎TaₓSe₂, MO₍₁₋ₓ₎WₓSSe, MoTe₂, WS₂, WSe₂, WSSe, WTe₂, WSTe, W₍₁₋ₓ₎NbₓS₂, W₍₁₋ₓ₎NbₓSe₂, PtS₂, PtSe₂, PtTe₂, PdSe₂, TaS₂, TaSe₂, Ta₍₁₋ₓ₎WₓS₂, Ta₍₁₋ₓ₎WₓSe₂, COPS₃, CrPS₄, Cu₍₁₋ₓ₎CrₓP₂S₆, NiPS₃, HfS₂, HfSe₂, HfTe₂, TiS₂, TiSe₂, TiTe₂, NbS₂, NbSe₂, NbTe₂, SnS₂, SnSe₂, SnTe₂, ReS₂, ReSe₂, ReTe₂ (wherein 0≤x≤1), or a combination thereof.

At least one of the two-dimensional material included in the second layer 120b and the third layer 120c may be a two-dimensional material other than a two-dimensional metal dichalcogenide, and may be, for example, Ta₂O₅, Ta₃N₅, TaON, Nb₂O₅, TiOx, NbOx, MnOx, VaOx, MnO₃, TaO₃, WO₃, MoCl₂, CrCl₃, RuCl₃, Bil₃, PbCl₄, GeS, GeSe, GaSe, In₂Se₃, GaTe, InS, InSe, InTe, h-BN, or a combination thereof, but is not limited thereto.

For example, the topological semimetal included in the first layer 120a and the two-dimensional material included in the second layer 120b and the third layer 120c may include at least one metal element in common, and thus the first layer 120a and the second layer 120b, and the first layer 120a and the third layer 120c may each form a continuous interface to have a substantially seamless interface, thereby reducing the contact resistance of the conductive wire 120.

The line width W1 of the first layer 120a may be less than about 10 nm as described above, and within the above range may be less than or equal to about 9 nm, less than or equal to about 8 nm, less than or equal to about 7 nm, less than or equal to about 5 nm, greater than or equal to about 1 nm and less than 10 nm, about 1 nm to about 9 nm, about 1 nm to about 8 nm, about 1 nm to about 7 nm, or about 1 nm to about 5 nm.

The line widths W2 and W3 of the second layer 120b and the third layer 120c may each be narrower than the line width W1 of the first layer 120a, for example, the line width W1 of the first layer may each be at least about 2 times wider than the line widths W2 and W3 of the second layer and the third layer, and may be at least about 3 times wider, at least about 5 times wider, or at least about 10 times wider within the above range, and may be about 2 to about 30 times wider, about 3 to about 30 times wider, about 5 to about 30 times wider, or about 10 to about 30 times wider within the above range. For example, the line widths of the second layer 120b and the third layer 120c may each be less than about 5 nm, and within the above range may be greater than or equal to about 0.5 nm and less than about 5 nm, about 0.5 nm to about 4 nm, about 0.5 nm to about 3 nm, or about 0.5 nm to about 2 nm.

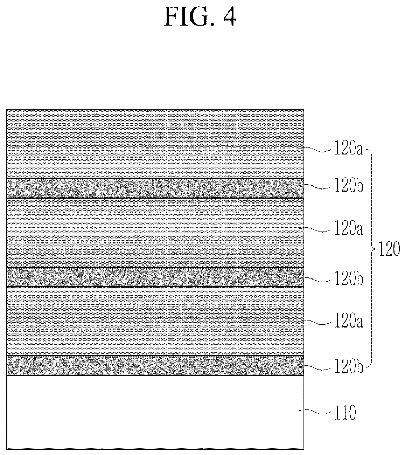

FIG. 4 is a schematic view showing another example of a conductive wire according to an embodiment.

Referring to FIG. 4, the conductive wire 120 according to an embodiment includes a first layer 120a and a second layer 120b formed adjacent to a dielectric layer 110, similar to the above-described embodiment, and the first layer 120a includes a topological semimetal and the second layer 120b includes a two-dimensional material.

However, unlike the above-described embodiment, the conductive wire 120 according to the present embodiment includes a plurality of the first layers 120a and a plurality of the second layers 120b (e.g., each of the layers in the plural), and the first layers 120a and second layers 120b are alternately stacked. The number of the first layer 120a and the second layer 120b may be 2 or more each, and for example, may be 2 to 20 each.

The conductive wire 120 according to the present example may more effectively control the characteristics of interfaces between the first layer 120a and the second layer 120b by controlling the van der Waals gap between the two-dimensional material and the topological semimetal by increasing an area where the topological semimetal and the two-dimensional material come into contact, and thus may exhibit further improved resistivity characteristics at a fine line width of less than about 10 nm (e.g., less than about 7 nm).

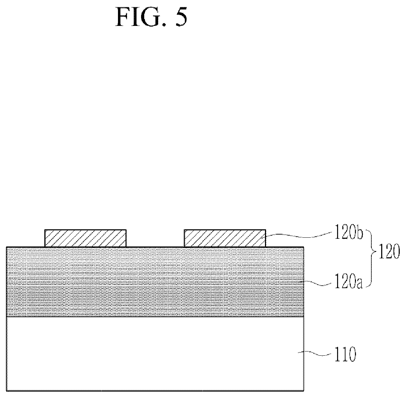

FIGS. 5 to 7 are schematic views showing further examples of a conductive wire according to an embodiment, respectively.

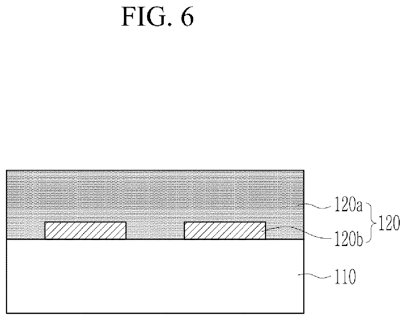

Referring to FIGS. 5 and 6, a conductive wire 120 according to an embodiment includes a first layer 120a and a second layer 120b formed adjacent to a dielectric layer 110, similar to the above-described example, wherein the first layer 120a includes a topological semimetal and the second layer 120b includes a two-dimensional material.

However, in the conductive wire 120 according to the present example, unlike the above-described example, the second layer 120b including the two-dimensional material is not in contact with the entire surface of the first layer 120a, but rather is in contact with a portion of the first layer 120a.

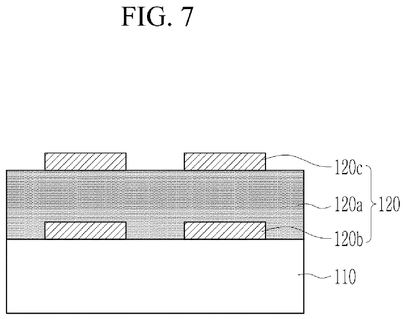

Likewise, referring to FIG. 7, a conductive wire 120 according to an embodiment includes a first layer 120a, a second layer 120b, and a third layer 120c formed adjacent to a dielectric layer 110 as in the above-described example, and the first layer 120a includes a topological semimetal, and the second layer 120b and the third layer 120c include a two-dimensional material.

However, in the conductive wire 120 according to the present embodiment, unlike the above-described embodiment, the second layer 120b and the third layer 120c including the two-dimensional material are not in contact with the entire surface of the first layer 120a, but rather are in contact with a portion of the first layer 120a.

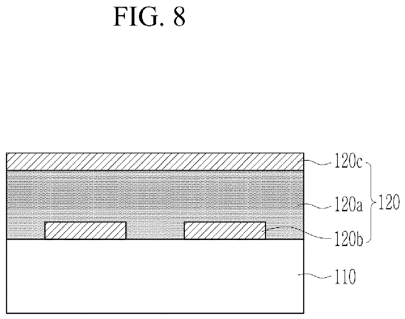

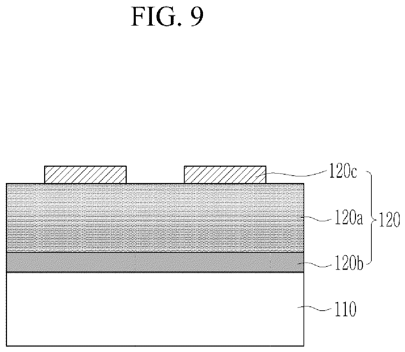

FIGS. 8 and 9 are schematic views showing further examples of conductive wires according to embodiments, respectively.

Referring to FIGS. 8 and 9, a conductive wire 120 according to an embodiment includes a first layer 120a, a second layer 120b, and a third layer 120c formed adjacent to a dielectric layer 110, similar to the above-described embodiment, and the first layer 120a includes a topological semimetal, and the second layer 120b and the third layer 120c include a two-dimensional material.

However, in the conductive wire 120 according to the present embodiment, unlike the above-described embodiment, one of the second layer 120b and the third layer 120c including the two-dimensional material is in contact with the entire surface of the first layer 120a, and the other of the second layer 120b and the third layer 120c is in contact with a portion of the first layer 120a.

The aforementioned conductive wire 120 may extend horizontally and/or vertically over a substrate (not shown) and may be buried in a trench of a dielectric layer 110 to form an interconnect structure that electrically connects one or more elements.

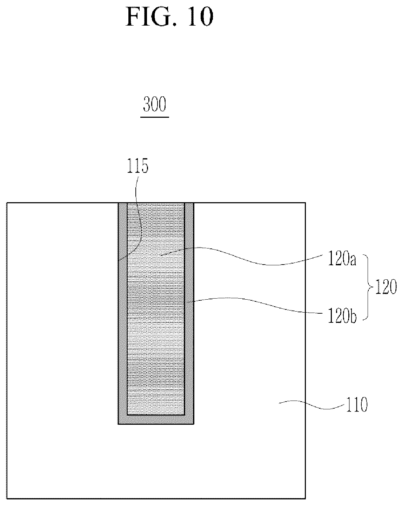

FIGS. 10 to 14 are each cross-sectional views showing examples of interconnect structures according to embodiments.

Referring to FIGS. 10 to 14, an interconnect structure 300 according to an embodiment includes one or more dielectric layers 110, and conductive wire 120 on at least one of the upper, lower, side, and inner portions of the dielectric layers 110.

The dielectric layer 110 may be supported by a substrate (not shown), and the substrate may be a semiconductor substrate. The semiconductor substrate may include, for example, a Group IV semiconductor material, a Group III-V semiconductor compound, or a Group II-VI semiconductor compound, for example, a Group IV semiconductor material including at least one or more of Si, Ge, Sn, and C, a Group III-V compound semiconductor material in which at least one or more of B, Ga, In, and Al are combined with at least one or more of N, P, As, and Sb, or a Group II-VI compound semiconductor material in which at least one or more of Be, Mg, Cd, and Zn are combined with at least one or more of O, S, Se, and Te. For example, the semiconductor substrate may include Si, Ge, SiC, SiGe, SiGeC, Ge alloy, GaAs, InAs, InP, sapphire, and the like, but is not limited thereto.

The substrate may include at least one semiconductor device (not shown) within and/or on the substrate, for example at least one of a transistor, a capacitor, a diode, and a resistor, but is not limited thereto.

The dielectric layer 110 may include, for example, a low-dielectric constant (a low-k) dielectric material. The dielectric layer 110 may include a dielectric having a dielectric constant of, for example, less than or equal to about 3.6, for example, less than or equal to about 3.5, less than or equal to about 3.3, less than or equal to about 3.0, less than or equal to about 2.8, or less than or equal to about 2.7 and greater than or equal to about 0.01, for example, greater than or equal to about 0.02, greater than or equal to about 0.03, greater than or equal to about 0.04, or greater than or equal to about 0.05. Here, the low-k material may be a material with a lower dielectric constant (k) than silicon oxide (SiO₂).

For example, the dielectric layer 110 may include a metal oxide, a carbon-doped metal oxide, a metal carbide, a hydrogenated metal carbide, a metal nitride, a metal oxynitride, or a combination thereof. The dielectric layer 110 may include AlO_{z} (0<z≤3/2, for example Al₂O₃), AIN, ZrOₓ (0<x≤2), HfOₓ (0<x≤2), SiO₂, SiCO, SiCN, SiON, SiCOH, AlSiO, BN (boron nitride, e.g., h-BN), or a combination thereof, but is not limited thereto.

The dielectric layer 110 may have one or more trenches 115. The trench 115 may have a narrow width of less than about 10 nm, and may have a width of less than or equal to about 9 nm, less than or equal to about 8 nm, less than or equal to about 7 nm, less than or equal to about 5 nm, greater than or equal to about 1 nm and less than 10 nm, about 1 nm and about 9 nm, about 1 nm and about 8 nm, about 1 nm and about 7 nm, or about 1 nm and about 5 nm. The trench 115 may have a high aspect ratio, may have an aspect ratio of greater than or equal to about 1:3 (width:depth), and may have an aspect ratio of about 1:3 to 1:50 within the above range. Here, the aspect ratio of the trench 115 is a ratio of the width to the depth of the trench 115.

The conductive wire 120 may be positioned at least on one of the upper, lower, side, and inner portions of the dielectric layer 110, and for example, the conductive wire 120 may be buried in a trench 115 of the dielectric layer 110.

The conductive wire 120 includes a topological semimetal and a two-dimensional material as described above, and may include, for example, a first layer 120a including a topological semimetal and a second layer 120b including a two-dimensional material (or a second layer 120b and a third layer 120c including a two-dimensional material). The description of the topological semimetal, two-dimensional material, first layer 120a, second layer 120b, and third layer 120c is as described above.

The first layer 120a including the topological semimetal and the second layer 120b including the two-dimensional material (or the second layer 120b and the third layer 120c including the two-dimensional material) may be in contact at least partially, and for example, as illustrated in FIGS. 10 to 14 , the second layer 120b including the two-dimensional material (or the second layer 120b and the third layer 120c including the two-dimensional material) may surround at least one surface of the first layer 120a including the topological semimetal. For example, a second layer 120b including a two-dimensional material (or a second layer 120b and a third layer 120c including a two-dimensional material) may be positioned between the dielectric layer 110 and the first layer 120a.

For example, as illustrated in FIG. 10, the conductive wire 120 within the interconnect structure 300 may be positioned at least on one of the upper, lower, side, and inner portions of the dielectric layer 110.

The first layer 120a may be filled in the trench 115 of the dielectric layer 110, and the second layer 120b may surround the lower surface and side surfaces of the first layer 120a within the trench 115 of the dielectric layer 110.

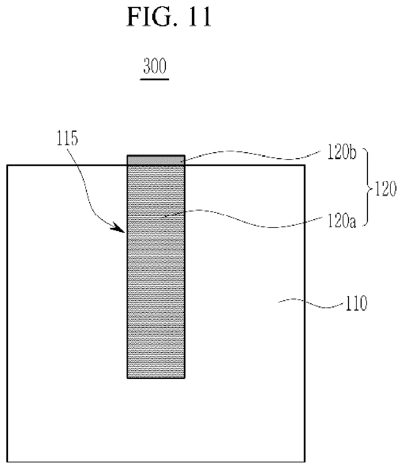

For example, as illustrated in FIG. 11, the conductive wire 120 within the interconnect structure 300 may be positioned at least on one of the upper, lower, side, and inner portions of the dielectric layer 110.

The first layer 120a may be filled in the trench 115 of the dielectric layer 110, and the second layer 120b may cover the upper surface of the first layer 120b.

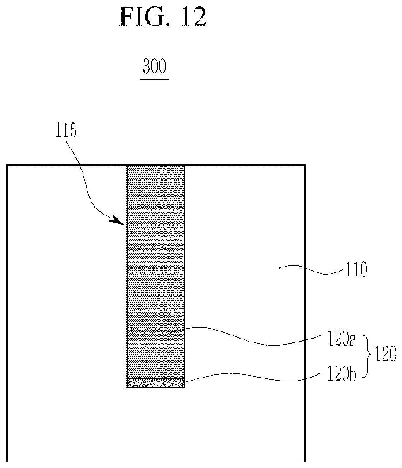

For example, as illustrated in FIG. 12, the conductive wire 120 within the interconnect structure 300 may be positioned at least on one of the upper, lower, side, and inner portions of the dielectric layer 110.

The first layer 120a may be filled in the trench 115 of the dielectric layer 110, and the second layer 120b may be in contact with the lower surface of the first layer 120a within the trench 115 of the dielectric layer 110.

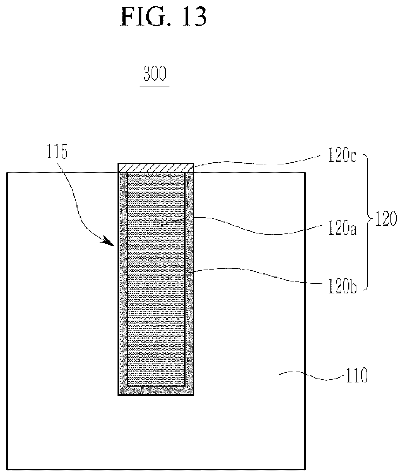

For example, as illustrated in FIG. 13, the conductive wire 120 within the interconnect structure 300 may be positioned at least on one of the upper, lower, side, and inner portions of the dielectric layer 110.

The first layer 120a may be filled in the trench 115 of the dielectric layer 110, the second layer 120b may surround the lower surface and side surfaces of the first layer 120a within the trench 115 of the dielectric layer 110, and the third layer 120c may cover the upper surface of the first layer 120a.

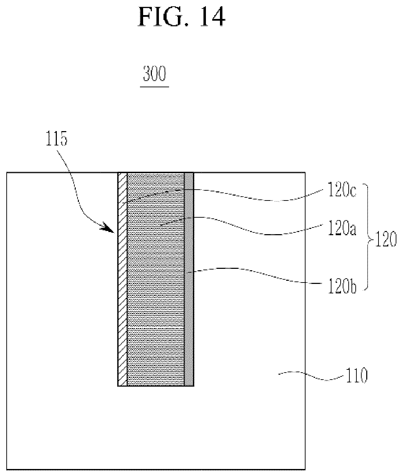

For example, as illustrated in FIG. 14, the conductive wire 120 within the interconnect structure 300 may be positioned at least on one of the upper, lower, side, and inner portions of the dielectric layer 110.

The first layer 120a may be filled in the trench 115 of the dielectric layer 110, and the second layer 120b and the third layer 120c may each surround the side surface of the first layer 120a within the trench 115 of the dielectric layer 110.

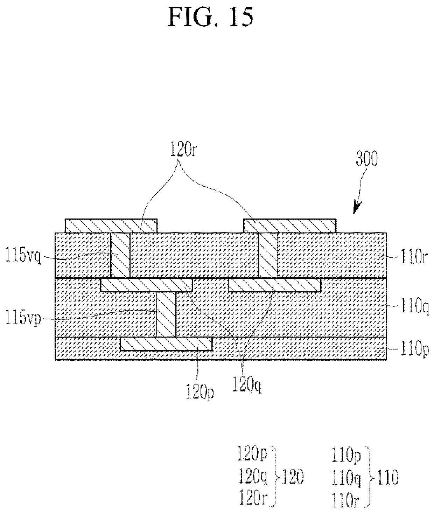

FIG. 15 is a cross-sectional view showing another example of an interconnect structure according to an embodiment.

Referring to FIG. 15, the interconnect structure 300 according to the present embodiment includes one or more dielectric layers 110 and conductive wire 120, similar to the aforementioned embodiment.

However, the dielectric layer 110 may include a plurality of dielectric layers 110p, 110q, and 110r positioned at different heights, and each dielectric layer 110p, 110q, and 110r may include the same or different materials.

The conductive wire 120 may include a plurality of conductive wires 120p, 120q, and 120r and vias 115vp and 115vq at different heights. That is, the conductive wire 120 may include a lower conductive wire 120p, an intermediate conductive wire 120q at a different height from the lower conductive wire 120p, an upper conductive wire 120r at a different height from the lower and intermediate conductive wires 120p and 120q, a via 115vp connecting the lower conductive wire 120p and the intermediate conductive wire 120q, and a via 115vq electrically connecting the intermediate conductive wire 120q and the upper conductive wire 120r. However, the present disclosure is not limited thereto and the interconnect structure 300 may further include another conductive wire at a different height or horizontally from the lower, intermediate, and/or upper conductive wires 120p, 120q, and 120r and another via electrically connecting a plurality of conductive wires at different heights.

The lower, intermediate, and upper conductive wires 120p, 120q, and 120r and vias 115vp and 115vq may be the same as the conductive wire 120 described above and may include topological semimetal and two-dimensional material as described above, and the specific description is as described above.

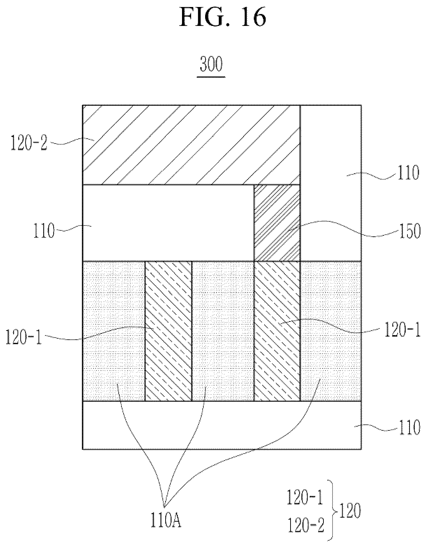

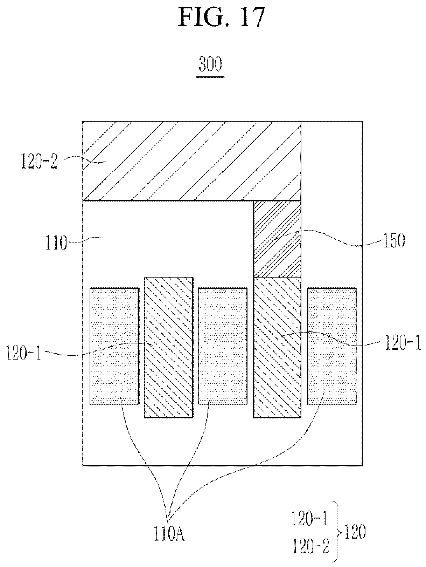

FIGS. 16 and 17 are cross-sectional views showing other examples of interconnect structures according to embodiments.

Referring to FIGS. 16 and 17, the interconnect structure 300 according to the present embodiment includes one or more dielectric layers 110 and conductive wire 120, similar to the aforementioned embodiment.

However, in the present embodiment, the dielectric layer 110 may be an airgap 110A or may include an airgap 110A. The airgap 110A may be a portion from which at least a portion of the dielectric layer 110 is removed, and may be a structure in which, for example, a portion of the dielectric layer 110 is etched to form a void (e.g., a trench) and then another structure (e.g., another dielectric layer 110) is placed thereon without filling the void.

For example, referring to FIG. 16, when all of the dielectric layer 110 between adjacent conductive wires 120 (lower conductive wires 120-1) is removed and another dielectric layer 110 is formed thereon, the dielectric layer between adjacent conductive wires 120 (lower conductive wires 120-1) may be an airgap 110A. Both sides of the airgap 110A may be in contact with the conductive wire 120 (lower conductive wire 120-1). The conductive wire 120 includes a lower conductive wire 120-1 and an upper conductive wire 120-2 positioned at different heights. The lower conductive wire 120-1 and the upper conductive wire 120-2 are electrically connected through a via 115. The via 115 may be surrounded by a dielectric layer 110.

For example, referring to FIG. 17, when a portion of the dielectric layer 110 between adjacent conductive wires 120 (lower conductive wires 120-1) is removed, the dielectric layer 110 may include an airgap 110A, and the airgap 110A may exist in an isolated form inside the dielectric layer 110. A dielectric layer 110 may be interposed between the airgap 110A and the conductive wire 120 (lower conductive wire 120-1).

The airgap 110A has a low dielectric constant, so it may effectively prevent interference between adjacent conductive wires 120 (lower conductive wires 120-1) and effectively prevent signal delay (RC delay) of semiconductor devices.

The width of the airgap 110A may be, for example, less than or equal to about 12 nm, and within the above range may be less than or equal to about 10 nm, less than or equal to about 8 nm, or less than or equal to about 6 nm, and within the above range may be about 2 nm to about 12 nm, about 2 nm to about 10 nm, about 2 nm to about 8 nm, or about 2 nm to about 6 nm.

The depth of the airgap 110A may be equal to or shallower than the thickness of the adjacent conductive wire 120 (lower conductive wire 120-1), for example, the depth of the airgap 110A may be less than or equal to about 90%, less than or equal to about 80%, or less than or equal to about 70% of the thickness of the conductive wire 120 (lower conductive wire 120-1), and within the above range may be about 10 to about 90%, about 10 to about 80%, about 10 to about 70%, about 20 to about 90%, about 20 to about 80%, or about 20 to about 70%.

The ratio of the width of the airgap 110A to the line width of the conductive wire 120 (lower conductive wire 120-1) may be greater than or equal to about 1.1, and within the above range may be greater than or equal to about 1.2, greater than or equal to about 1.3, greater than or equal to about 1.5, and within the above range may be about 1.1 to about 5, about 1.2 to about 5, about 1.3 to about 5, or about 1.5 to about 5.

The conductive wire 120 includes a lower conductive wire 120-1 and an upper conductive wire 120-2 positioned at different heights. The lower conductive wire 120-1 may extend, for example, along a first direction (e.g., X-direction) and the upper conductive wire 120-1 may extend along a second direction (e.g., Y-direction) perpendicular to the first direction.

The lower conductive wire 120-1 and the upper conductive wire 120-2 are electrically connected through a via 115. The via 115 may be surrounded by a dielectric layer 110. The size of the via 115 may be determined according to the line width of the lower conductive wire 120-1, and as the line width of the lower conductive wire 120-1 becomes narrower as described above, the size of the via 115 may also become smaller. For example, the width of the via 115 may be less than about 10 nm, and within the range may be less than or equal to about 9 nm, less than or equal to about 8 nm, less than or equal to about 7 nm, less than or equal to about 5 nm, greater than or equal to about 1 nm and less than about 10 nm, about 1 nm to about 9 nm, about 1 nm to about 8 nm, about 1 nm to about 7 nm, or about 1 nm to about 5 nm. The via 115 may include a conductor, such as a topological semimetal and/or a two-dimensional material included in the conductive wire 120 described above.

The aforementioned conductive wire 120 and/or interconnect structure 300 may be included in an integrated circuit device. The integrated circuit device may include DRAM or logic device, but is not limited thereto. The integrated circuit device may include unit devices including, for example, a transistor, a capacitor, a diode, a resistor, or a combination thereof, which are electrically connected to the conductive wire 120 described above. The conductive wire 120 and/or interconnect structure 300 may be applied to wire (e.g., bit lines, word lines, etc.) and/or BEOL (back end of line) structures that are connected to unit devices such as transistors.

For example, the transistor may have various structures, for example FinFET, GAAFET, MBCFET, CFET or VFET, but is not limited thereto.

The aforementioned conductive wire 120, interconnect structure 300, and/or integrated circuit devices may be included in various electronic devices. The electronic devices may include mobile devices, computers, laptops, tablet PCs, smart watches, sensors, digital cameras, e-books, network devices, vehicle navigation systems, Internet of Things (IoT) devices, Internet of Everything (IoE) devices, drones, door locks, safes, automated teller machines (ATMs), security devices, medical devices, or automotive electrical components, but are not limited thereto.

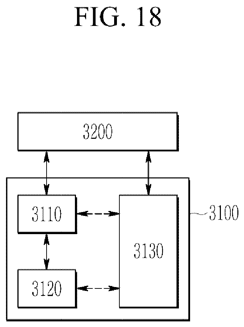

FIG. 18 is a conceptual view showing an example of an electronic device according to an embodiment.

Referring to FIG. 18, an electronic device 3100 according to an embodiment may include a memory unit 3110, an arithmetic logic unit 3120, and a control unit 3130, which may be electrically connected. For example, the memory unit 3110, the arithmetic logic unit 3120, and the control unit 3130 may be implemented as a single integrated circuit device (semiconductor chip), and may be monolithically integrated on a single substrate to be implemented as a single integrated circuit device (semiconductor chip). The memory unit 3110, the arithmetic logic unit 3120, and the control unit 3130 may each independently include a transistor, a capacitor, a diode, a resistor, or a combination thereof. The electronic device 3100 may be connected to one or more input/output devices 3200.

Hereinafter, the embodiments are illustrated in more detail with reference to examples. However, these examples are exemplary, and the present scope is not limited thereto.

### Manufacture of Conductive Wire

### Example

MoS₂ is grown on SiO₂ in a chemical vapor deposition (CVD) method. Subsequently, the MoS₂ grown by the CVD is transferred onto a sapphire substrate (the substrate having a thickness: 650 µm) to form a 0.9 nm-thick MoS₂ two-dimensional material layer on the substrate. After depositing Mo on the MoS₂ two-dimensional material layer, and increasing a temperature to 750 °C, red phosphorous is supplied thereon for 10 minutes to form a MoP topological semimetal layer, thereby forming a wire of the MoS₂ two-dimensional material layer/the MoP topological semimetal layer with a total thickness (a line width) of 4 nm. Multiple wires are formed by changing the thicknesses (line widths) of the wire within a range of about 2 nm to 7 nm.

### Reference Example

Wires of a MoP topological semimetal layer are formed by depositing Mo on a sapphire substrate (a thickness: 650 µm) and increasing a temperature to 800 °C and then, supplying red phosphorous thereon for 1 hour. The wires are formed to have various line widths within a range of about 3 nm to 27 nm.

### Evaluation

The wires according to Example and Reference Example are evaluated with respect to resistance characteristics.

Resistivity of wires is calculated by multiplying sheet resistance and a thickness, wherein the sheet resistance is measured by using a 4-point probe (AIT), and the thickness is measured by using an X-ray reflectometer (X'PERT-PRO MRD). A relative ratio of resistivity (R) to maximum resistivity (Rₘₐₓ) is used.

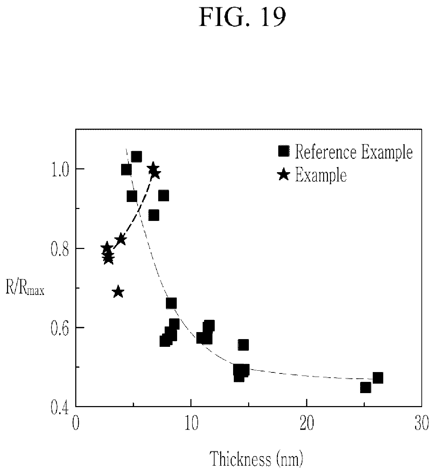

The results are shown in FIG. 19.

FIG. 19 is a graph showing the resistivity characteristics based on the thickness (nm) of wire according to Example and Reference Example.

Referring to FIG. 19, the wires according to Example do not show an increase in resistivity due to a decrease in thickness in the thickness (line width) of about 7 nm or less, but rather show a tendency to decrease, compared with the wires according to Reference Example. Accordingly, the wires according to Example may be expected to prevent deterioration of electrical characteristics without a sharp increase in resistivity even at a fine line width of less than about 10 nm (about 7 nm or less).

While the embodiments of the present disclosure have been described in detail, it is to be understood that the disclosure is not limited to the disclosed embodiments, but on the contrary, is intended to cover various modifications and equivalent arrangements included within the scope of the appended claims.

## Claims

1. A conductive wire comprising a topological semimetal and a two-dimensional material.

2. The conductive wire of claim 1, wherein the conductive wire comprises
a first layer comprising the topological semimetal, and
a second layer at least partially in contact with the first layer, the second layer comprising the two-dimensional material.

3. The conductive wire of claim 2, wherein
a line width of the first layer is less than 10 nanometers, and
a line width of the second layer is narrower than a line width of the first layer.

4. The conductive wire of claim 3, wherein the line width of the first layer is 2 to 30 times wider than the line width of the second layer.

5. The conductive wire of claim 2, 3 or 4, wherein the first layer has a first surface and a second surface facing each other, and the second layer is in contact with the first surface of the first layer,
wherein the conductive wire further comprises a third layer in contact with the second surface of the first layer, and the third layer comprises the two-dimensional material.

6. The conductive wire of any of claims 2 to 5, wherein
the first layer and the second layer are included in the plural, and
the first layer and the second layer are alternately stacked.

7. The conductive wire of any preceding claim, wherein the two-dimensional material comprises a two-dimensional metal dichalcogenide, a two-dimensional metal oxide, a two-dimensional metal halide, graphene, phosphorene, silicene, germanene, stanene, borophene, hexagonal boron nitride, or a combination thereof.

8. The conductive wire of any preceding claim, wherein the topological semimetal is represented by Chemical Formula 1:
Chemical Formula 1 M¹Xₐ
wherein, in Chemical Formula 1,
M¹ is Zr, Nb, Ru, Al, Co, W, Mo, Ti, Ta, Ni, Pt, Cr, Rh, Ir, Pd, Os, Hf, Re, Sn, Mn, Ga, or a combination thereof,
X is C, N, P, As, Sb, S, Se, Te, or a combination thereof, and
a is a number determined by the stoichiometry of M¹ and X.

9. The conductive wire of claim 8, wherein the two-dimensional material is different from the topological semimetal and is represented by Chemical Formula 2:
Chemical Formula 2 M²Y₂
wherein, in Chemical Formula 2,
M² is Mo, W, Nb, Ti, Ta, Pt, Pd, Co, Cr, Ni, Hf, Re, Sn, Zr, Mn, Ga, or a combination thereof, and
Y is S, Se, Te, or a combination thereof, and optionally wherein M¹ of Chemical Formula 1 and M² of Chemical Formula 2 comprises at least one metal in common.

10. An interconnect structure comprising:
one or more dielectric layers, and
a first conductive wire according to any preceding claim positioned on at least one of an upper portion, a lower portion, a side portion, and an inner portion of the dielectric layers.

11. The interconnect structure of claim 10, wherein the dielectric layer has a trench with a width of less than or equal to 10 nanometers,
wherein the first conductive wire comprises
a first layer positioned within the trench, the first layer comprising the topological semimetal, and
a second layer contacting at least one of a lower portion, an upper portion, and a side portion of the first layer, the second layer comprising the two-dimensional material.

12. The interconnect structure of claim 11, wherein the second layer is positioned between the dielectric layer and the first layer.

13. The interconnect structure of claim 11 or 12, wherein the dielectric layer is an airgap or comprises an airgap.

14. The interconnect structure of any of claims 10 to 13, further comprising
a second conductive wire positioned at a different height from the first conductive wire, and
a via electrically connecting the first conductive wire and the second conductive wire, respectively,
wherein the via comprises the topological semimetal, the two-dimensional material, or a combination thereof.

15. A semiconductor device comprising the conductive wire of any of claims 1 to 9.
